# EUROPEAN PATENT SPECIFICATION

(11) **EP 1 722 926 B1**
(45) Date of publication and mention of the grant of the patent: **19.08.2009**
(21) Application number: 05711980.2
(22) Date of filing: 25.01.2005
(51) Int. Cl.: B24D 9/08, B24B 37/04, B24B 53/007

(54) **UNDULATED PAD CONDITIONER AND METHOD OF USING SAME**
GEWELLTE KISSENAUFBEREITUNGSVORRICHTUNG UND VERWENDUNGSVERFAHREN DAFÜR
CONDITIONNEUR DE PLAQUETTES ET SON PROCEDE D'UTILISATION

(30) Priority: 09.03.2004 US 797892
(43) Date of publication of application: 22.11.2006
(73) Proprietor: 3M Innovative Properties Company, St. Paul MN 55133-3427 (US)
(72) Inventor: PALMGREN, Gary M., 3M Center, Saint Paul, Minnesota 55133-3427 (US)
(74) Representative: von Kreisler Selting Werner
(86) International application number: PCT/US2005/002310
(87) International publication number: WO 2005/095059

(56) References cited:
- FR-A- 1 596 322
- US-A- 2 990 661
- US-A- 6 093 280

## Description

### BACKGROUND

The present invention relates generally to pad conditioners used to condition polishing pads. An example of such a pad according to the preamble of claim 1 is disclosed in US 2 999 661A. The polishing pads can be configured for polishing a variety of materials, including, for example, plastics, glasses, and semiconductor wafers. More particularly, the present invention relates to a pad conditioner with an undulated surface.

During manufacture, semiconductor wafers used in semiconductor fabrication typically undergo numerous processing steps, including deposition, patterning, and etching steps. Details of these manufacturing steps for semiconductor wafers are reported by Tonshoff et al., "Abrasive Machining of Silicon", published in the Annals of the International Institution for Production Engineering Research, (Volume 39/2/1990), pp. 621-635. In each manufacturing step, it is often necessary or desirable to modify or refine an exposed surface of the wafer in order to prepare the wafer for subsequent fabrication or manufacturing steps.

For example, after a deposition step, the deposited material or layer on a wafer surface generally needs further processing before additional deposition or subsequent processing occurs. In another example, after an etching step, there is often a need to deposit conducting or insulating materials in layers on the etched surface areas of a wafer.

At each step, it is often desirable to achieve a pre-determined level of surface uniformity. It is also desirable to remove surface defects such as pits and scratches. Such surface irregularities may affect the performance of the semiconductor device or create problems during subsequent processing steps.

One method of modifying or refining exposed surfaces of a wafer involves treating the wafer surface with a slurry containing a plurality of loose abrasive particles dispersed in a liquid. Typically, this slurry is applied to a polishing pad and the wafer surface is then moved against the pad in order to remove or take material off of the wafer surface. The slurry may also contain agents that chemically react with the wafer surface. This type of process is commonly referred to as a chemical-mechanical planarization or polishing (CMP) process. A variation of the CMP process employs a fixed abrasive article as the polishing pad, typically with an abrasive-free working fluid.

One problem with CMP is that the process must be carefully monitored in order to achieve a desired wafer surface topography. The use history of the polishing pad, for example may affect the polishing results. During CMP, the surface of polishing pads for abrasive-slurry type CMP operations become glazed, thus nonreceptive to accommodating or dispensing the abrasive slurry, and otherwise incapable of polishing at a satisfactory rate and uniformity. The polishing pad surface is conditioned so that it is maintained in a proper form for CMP.

Other processes also use polishing pads that require conditioning. For example, polishing pads for glass and plastic polishing may require conditioning. In certain applications, the polishing pads can contain abrasives. U.S. Pat. No. 5,958,794 (Bruxvoort et al.), for example, discloses a fixed abrasive article for polishing wafers.

The polishing pad is conditioned with an abrasive article commonly referred to as a pad conditioner. After repeated conditioning steps, the pad conditioner eventually becomes spent. The pad conditioner becomes spent when it becomes incapable of conditioning the polishing pad at a satisfactory rate and uniformity. Accordingly, the value of a pad conditioner is increased if its useful life can be extended.

After repeated conditioning operations, the polishing pad also becomes spent and needs to be replaced. During replacement of the polishing pad, the CMP apparatus is unavailable and productivity is reduced. A pad conditioner that is too aggressive and abrades the polishing pad too fast can compromise productivity. Most abrasive articles, including pad conditioners, are optimized for one process and one type of workpiece. For example, if a selected pad conditioner is too aggressive and abrades the polishing pad too rapidly, an alternate pad conditioner with a lower cut rate can be used in its place. Managing a supply of various pad conditioner types for various workpieces, however, introduces complexity to the manufacturing environment and increases inventory costs. Accordingly, the value of a pad conditioner is increased if it can be optimized for use in multiple processes and for a variety of workpieces.

The US 2,990,661 discloses a backing disk having a plurality of ribs, having sheet abutting portions lying in substantially a common plane and having intervening offset portions, each provided with an aperture remote from the edge of the disk to accommodate air flow through the space between said offset portion and an abrasive disk or sheet carried by said backing disk.

The US 6,093,280 discloses a conditioning wafer for conditioning a polishing pad employed in chemical-mechanical polishing of an integrated circuit substrate. The conditioning wafer includes a disk having a conditioning surface and a plurality of abrasive particles secured on the conditioning surface of the disk. Furthermore, the abrasive particles engage with the polishing pad when the conditioning wafer contacts the polishing pad during conditioning of the polishing pad.

### SUMMARY

The present invention provides an abrasive article for conditioning a polishing pad as disclosed in the appended claim 1.

Also provided is a method of conditioning a polishing pad as per claim 16.

### BRIEF DECRIPTION OF THE DRAWINGS

FIG. 1 is a perspective view of an exemplary pad conditioner;

FIG. 2 is a perspective view of an exemplary undulating disk;

FIG. 3 is a cross-sectional side view of an exemplary undulating disk with an abrasive disk attached;

FIG. 4 is a bottom side view of an exemplary abrasive disk having two sets of indexing holes;

FIG. 5 is a graph showing cumulative cut rates over time; and

FIG. 6 is a graph showing cut rates versus duration of use.

### DETAILED DESCRIPTION

Throughout this application, the following definitions apply:

An "undulated" surface is a surface that is non-planar. The undulated surface includes raised portions and recessed portions. The undulated surface can have a pattern or be random.

A "patterned undulated surface" is an undulated surface with a discernable design or configuration. Pattern undulated surfaces include, for example, waves, spirals, and steps. A wave pattern is formed when the undulated surface transitions from raised portions to recessed portions in a sinusoidal curve like fashion. The sinusoidal curves are formed perpendicular to the surface and generally follow radii about the center of the surface. A step pattern is similar to a wave pattern except the raised and recessed portions have flat areas. A spiral pattern is formed when the raised surface forms a spiral about the center of the surface. A patterned undulated surface can include other patterns, including, for example, checkerboard, polka-dot, striped, and the like.

The term "offset" is used to refer to the distance between the plane at the center of a raised portion and the plane at the center of a recessed portion of an undulated surface. For example, if an undulated surface has a generally planar surface with two cylinders extending 2 mm above the planar surface such that the central axis of each cylinder is perpendicular to the planar surface, the offset for the undulated surface would be 2 mm. The offset can be measured at the surface of the undulating disk, described herein, or at the abrasive surface.

The term "polishing pad" is used to refer to a material, such as a polymeric sheet, foam, fabric, or a fixed abrasive article, that is used to modify the surface of a workpiece in a frictional polishing process. The polishing process usually reduces the depth of scratches or pits on the surface of the workpiece. Polishing pads are typically used with a working fluid and can be used with or without abrasive slurries. A pad conditioner modifies the surface of a polishing pad that in turn modifies the surface of a workpiece.

The present invention provides a pad conditioner having an undulated surface. Deforming the pad conditioner with an undulating disk creates the undulated surface. The undulating disk allows the user to adjust the abrading properties of the pad conditioner. For example, if the cut rate of the selected pad conditioner increases as the surface contact area of the selected pad conditioner and polishing pad increases, the pad conditioner can be deformed to reduce its cut rate. The type and extent of deformation of the pad conditioner adjusts the abrading properties of the pad conditioner. Conversely, in other configurations, the cut rate may increase as the pad conditioner transitions from having a substantially flat surface to having an undulated surface.

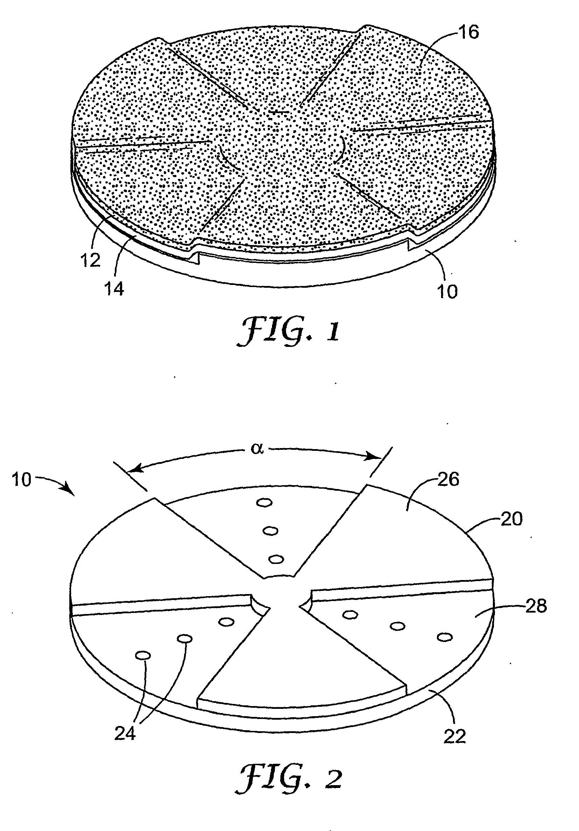

FIG. 1 shows one embodiment of an undulated pad conditioner. As shown in FIG. 1, the undulated pad conditioner includes undulating disk 10, substrate 14, and abrasive layer 12. The abrasive layer 12 has an abrasive surface 16.

The abrasive layer 12 can be constructed to include a backing with an abrasive surface 16 affixed onto the backing. An abrasive layer 12 constructed with a backing may eliminate the need for substrate 14.

The abrasive surface 16 is a textured surface suitable for conditioning a polishing pad. The abrasive surface, for example, can include abrasive particles and a matrix material, such as described in U.S. Pat. No. 6,123,612 (Goers), incorporated herein by reference. Other techniques known in the art, including, for example, electroplating, sintering, and brazing can also be used to adhere the abrasive particles to a backing to create an abrasive surface.

The size and type of abrasive particles are selected based on the intended application. Suitable abrasive particles include, for example, fused aluminum oxide, ceramic aluminum oxide, heat treated aluminum oxide, silicon carbide, boron carbide, tungsten carbide, alumina zirconia, iron oxide, diamond (natural and synthetic), ceria, cubic boron nitride, garnet, carborundum, boron suboxide, and combinations thereof. In certain preferred embodiments, the abrasive particles have a Mohs hardness of at least about 8. In other embodiments, the Mohs hardness is at least about 9. In yet other embodiments, the Mohs hardness is at least about 10.

Abrasive particles useful in the present invention have an average size of at least about 3 micrometers. In certain embodiments, the abrasive particles have an average size of at least about 20 micrometers. In other embodiments, the abrasive particles have an average size of at least about 40 micrometers. In yet further embodiments, the abrasive particles have an average size of at least about 80 micrometers. Abrasive particles useful in the present invention have an average size of less than about 1000 micrometers. In certain embodiments, the abrasive particles have an average size less than about 600 micrometers. In other embodiments, the abrasive particles have an average size less than about 300 micrometers.

In certain embodiments, the abrasive particles may be in the form of abrasive agglomerates that comprise a plurality of individual abrasive particles bonded together to form a unitary particulate. The abrasive agglomerates may be irregularly shaped or may have a predetermined shape. The abrasive particles may further include a surface treatment, such as, for example, a coupling agent, or a metal or ceramic coating.

The matrix material used in the abrasive layer to affix the abrasive particles can include a metal, such as, for example, tin, bronze, silver, iron, and alloys or combinations thereof. The matrix material may also include other metals and metal alloys, including, for example, stainless steel, titanium, titanium alloys, zirconium, zirconium alloys, nickel, and nickel alloys. The substrate 36 can be made of any suitable material, such as, for example, stainless steel foil, nickel, or nickel-chromium-iron alloys available under the trade designation "INCONEL", available from McMaster-Carr Supply Co., Chicago, Illinois.

In whatever form, the abrasive surface is constructed to grind, polish, or otherwise abrade the surface of a polishing pad. The surface is typically abraded with relative movement between the abrasive surface and the polishing pad to generate the friction required for the desired abrasive application.

FIG. 2 shows a perspective view of an exemplary undulating disk 10. As shown in FIG. 2, the undulating disk 10 includes raised portions 26, recessed portions 28, an undulating plate 20, and a backing plate 22. The undulating plate 20 has three arms that extend out from the center separated by a void having an angle α. The arms form the raised portions 26 of the undulating disk. The void areas of the undulating plate create the recessed portions 28. In certain preferred embodiments, the undulating disk has three arms connected by a circular area wherein ∝ is about 40 degrees. The undulating plate 20 and backing plate 22 can be separate pieces as shown in FIG. 2, or they can be integrated and formed as one piece as shown in FIG. 1.

In certain preferred embodiments, the raised portions 26 of the undulating disk 10 extend at least 0.5 mm above the recessed portions 28 to create an offset of at least 0.5 mm. Other embodiments have undulating disks with larger offsets, such as, for example, 0.75 mm or 1.0 mm. In certain embodiments, the undulating disk has offsets between 0.050 mm and 0.5 mm, including, for example, an offset of 0.25 mm.

The relative surface areas of the raised portions and the recessed portions of the undulating disk can vary. In certain preferred embodiments, the surface area of the raised portions comprises at least about 50 percent of the surface of the undulating disk. The surface area of the raised portions for some embodiments comprises at least about 33 percent of the surface of the undulating disk. In other embodiments, the surface area of the raised portions comprises at least 10 percent of the surface of the undulating disk. In certain preferred embodiments, the surface area of the raised portions comprises less than about 50 percent of the surface of the undulating disk. The surface area of the raised portions for some embodiments comprises less than about 66 percent of the surface of the undulating disk. In other embodiments, the surface area of the raised portions comprises less than about 90 percent of the surface of the undulating disk.

The raised portions 26 of the undulating disk 10 can have a pattern or be random. In certain preferred embodiments, the undulating disk has a step pattern as shown in FIG. 2. In other embodiments, the undulating disk has a sinusoidal wave pattern.

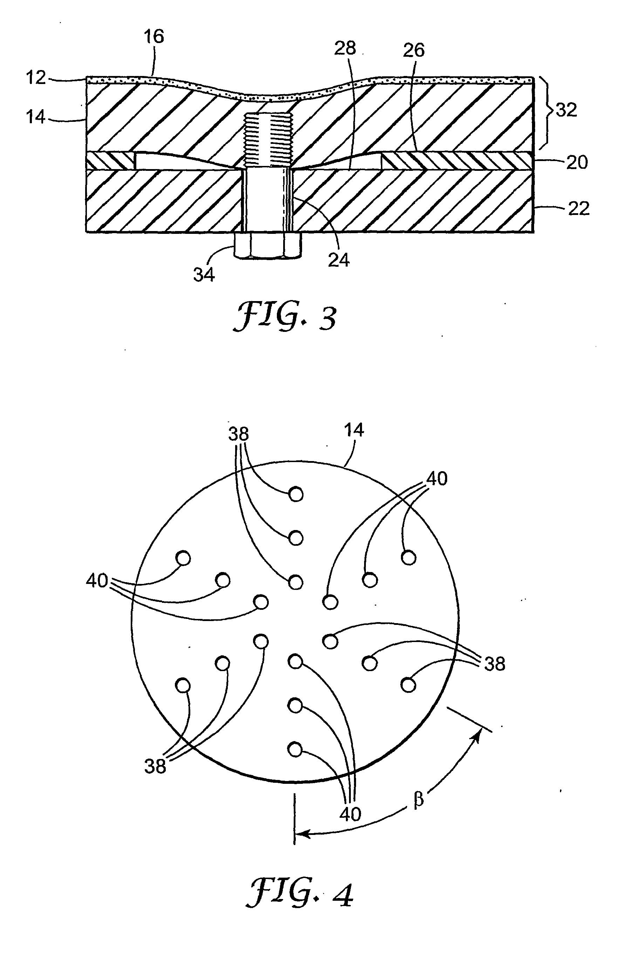

FIG. 3 is a cross-sectional side view of an exemplary undulating disk 10 with an abrasive disk 32 attached. As shown in FIG. 3, the abrasive disk 32 has a substrate 14 and an abrasive layer 12 having an abrasive surface 16. The backing plate 22 of the undulating disk 10 includes substrate mounting holes that allow removable fastener 34 to pass through. In certain preferred embodiments, the substrate 14 has threaded holes that align with the substrate mounting holes 24. The abrasive disk 32 is attached to the undulating disk with fastener 34. Fastener 34 is then used to deform the substrate 14 to create an undulated abrasive surface 16.

Loosening or tightening fastener 34 adjusts the offset of the abrasive surface. For example, if a greater offset is desired, fastener 34 can be tightened. Likewise, loosening fastener 34 will reduce the offset of the abrasive surface. The materials and dimensions selected for the abrasive disk 32 and the undulating disk 10 will affect the offset that can be achieved on the abrasive surface 16. In certain preferred embodiments, the substrate 14 is designed to be more flexible than the backing plate 22. For example, while the substrate 14 and the backing plate 22 can be made of similar material, the backing plate can be designed to be thicker (i.e. less flexible) than the substrate. Alternatively, the backing plate and the substrate can be made from different materials.

In certain embodiments, the undulating disk is made from metal, such as, for example, steel or aluminum. The undulating disk can also be made from other materials including, for example, plastic, rubber, or ceramic. The undulating disk can also be made from a combination of materials. For example, the backing plate may be made from a relatively stiff material, such as, for example, metal, and the undulating plate could be made from a relatively pliable material such as, for example, rubber.

In certain preferred embodiments, the substrate is made from polycarbonate. The substrate can also be made from other materials including, for example, filled and unfilled plastics such as epoxy, polysulfone, phenolics, polyacrylates, polymethacrylates, polyolefins, styrene, and combinations thereof.

The fastener 34 used for the embodiment shown in FIG. 3 is a bolt. Other fasteners capable of holding the abrasive disk to the undulating disk can also be used. The fastener can temporarily affix the abrasive disk to the undulating disk, such as with a removable threaded screw or bolt. Examples of temporary or removable fasteners include, for example, screws, bolts, pins, rivets, snaps, clamps, hook and loop systems, clips, and the like.

The orientation of the fasteners can be varied. For example, the embodiment shown in FIG. 3 orients that bolt such that the through hole is in the undulating disk and the threaded hole is in the abrasive disk. The orientation can be reversed such that the through holes for the bolt are in the abrasive layer and the threaded holes are in the undulating disk.

FIG. 4 is a bottom side view of an exemplary substrate of an abrasive disk. As shown in FIG. 4, the substrate 14 has a first set of indexing holes 38 and a second set of indexing holes 40. The first and second set of indexing holes 38, 40 are offset about the center of the abrasive disk by angle β. The indexing holes allow the abrasive disk to be affixed to the undulating disk in more than one position. Each set of indexing holes 38, 40 is configured to align with the substrate mounting holes 24. For example, the abrasive disk shown in FIG. 4 could be used with an undulating disk similar to FIG. 2 having nine substrate mounting holes. The nine substrate mounting holes are capable of fastening the abrasive disk using either the first set of indexing holes 38 or the second set of indexing holes 40. After a period of use, the abrasive disk can be removed and subsequently reattached to the undulating disk using the alternate set of indexing holes to expose unused portions of the abrasive surface. In this manner, the useful life of the abrasive disk is extended.

Other multiples of indexing holes can also be used. For example, if the undulating disk has four recessed portions each having one substrate mounting hole, for a total of four holes, the abrasive disk could have three or more sets of indexing holes, each set having four holes. Alternatively, the abrasive disk can be indexed by varying the fasteners between the recessed portions. In this manner, the abrasive surface is not rotated relative to the undulating disk to index the abrasive surface. For example, if an undulating disk has eight recessed portions, the offset of the abrasive surface could be adjusted using fasteners in only four of the recessed portions. The abrasive surface could then be indexed by moving the fasteners to the remaining four recessed portions.

In certain preferred embodiments, the abrasive surface can be indexed without removing the pad conditioner from the conditioner assembly. This can be accomplished by any means known in the art including radially slotted mounting holes in the undulating disk. In other embodiments, the abrasive surface can be indexed while the conditioner pad is conditioning the polishing pad. This can be accomplished by any means known in the art including, for example, coaxial shafts for the undulating disk and the abrasive disk or a planetary gear between the undulating disk and the abrasive disk. In such embodiments, the abrasive disk can be affixed to the undulating disk using a series of radial grooves that engage fasteners that can slide within the groove. The grooves can be positioned on the surface of the undulating disk with the corresponding sliding fasteners affixed to the abrasive disk.

Advantages and other embodiments of this invention are further illustrated by the following examples, but the particular materials and amounts thereof recited in these examples, as well as other conditions and details, should not be construed to unduly limit this invention. For example, the undulating disk can be one integral body or be a combination of an undulating plate and backing plate. Further, the examples condition polycarbonate instead of a polishing pad to provide a test piece with a more readily measured cut rate and cumulative cut. The examples show that an undulated pad conditioner can be used to adjust the material removal rate and reduce the variability in cut rate over time of the pad conditioner. All parts and percentages are by weight unless otherwise indicated.

### EXAMPLE 1A.

An abrasive disk was prepared by attaching an abrasive material to a substrate using double-sided tape. The abrasive material was "472L, 40µm, silicon carbide microfinishing film" available from 3M Co., St. Paul, MN, cut into an 83 mm diameter disk with a 19 mm center hole. The substrate was a 6.3 mm thick, 83 mm diameter polycarbonate disk. The substrate was drilled and tapped with six 10-24 UNC threads placed equally distant apart from one another on a 30 mm diameter.

An undulating disk was prepared by placing an undulating plate onto a backing plate. The undulating plate was a 0.6 mm thick sheet of polypropylene cut to a 85 mm diameter. The undulating plate was configured with three arms similar to undulating plate 20 shown in FIG. 2. The angle α was 40 degrees. The backing plate was a 1.27 mm aluminum plate cut to a 100 mm diameter. Six through holes were drilled in the backing plate on a 30 mm diameter to match the threaded holes in the substrate.

The abrasive disk was attached to the undulating disk using three screws. The screws were used to pull the substrate of the abrasive disk into contact with the backing plate of the undulating disk at the three recessed portions.

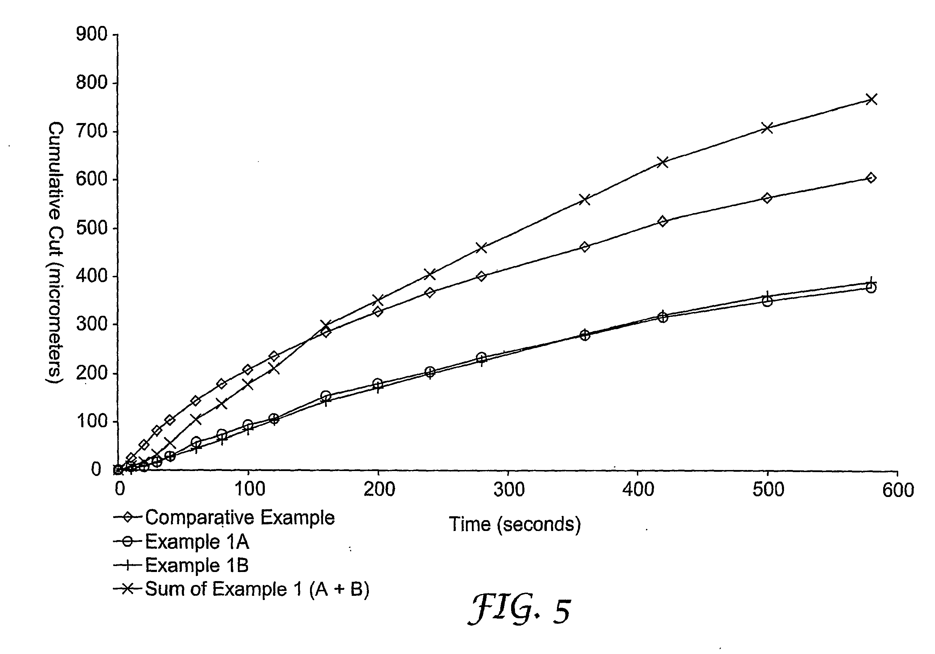

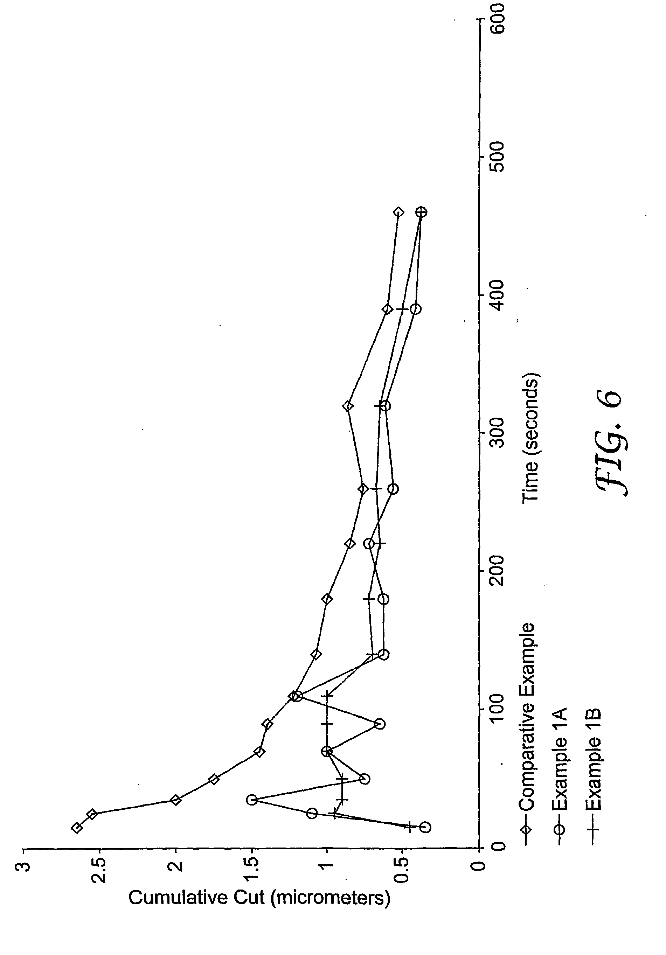

A Gerber Apex lens polishing machine, available from Gerber-Coburn, Muskogee, OK, was used for testing the abrasion performance. A 12 mm thick polycarbonate disk was used as the test workpiece. Polycarbonate was used instead of a polishing pad to provide a test piece with a more readily measured cut rate and cumulative cut. The undulated pad conditioner was tested by measuring the cumulative cut of the workpiece. The results are shown in Table 1 and FIGS. 5 and 6.

### EXAMPLE 1B.

For Example 1B, the abrasive disk used for Example 1A was rotated (i.e. indexed) about the undulating disk 60 degrees and re-tested using the same test as Example 1A. After rotation, the three screws were located in the same through holes of the undulating disk of Example 1 A and the alternate threaded holes of the abrasive disk. The screws were used to pull the substrate of the abrasive disk into contact with the backing plate of the undulating disk at the three recessed portions. The undulated pad conditioner was tested by measuring the cumulative cut of the workpiece. The results are shown in Table 1 and FIGS. 5 and 6.

### COMPARATIVE EXAMPLE 1.

Comparative Example 1 was prepared in the same manner as Example 1A except the undulating plate was removed to eliminate the undulating surface. Six screws were used to hold the substrate of the abrasive layer to the backing plate. The flat pad conditioner was tested by measuring the cumulative cut of the workpiece. The results are shown in Table 1 and FIGS. 5 and 6.

**Table 1. Cumulative Cut (µm) versus Time (seconds)**

| Time | Comparative Example 1 | Example 1A | Example 1B | Sum of Example 1 (A+B) |
|---|---|---|---|---|
| 0 | 0 | 0 | 0 | 0 |
| 10 | 25 | 7 | 1 | 8 |
| 20 | 53 | 7 | 9 | 16 |
| 30 | 82 | 17 | 16 | 33 |
| 40 | 104 | 29 | 28 | 57 |
| 60 | 144 | 59 | 46 | 105 |
| 80 | 179 | 74 | 64 | 138 |
| 100 | 208 | 94 | 84 | 178 |
| 120 | 236 | 107 | 104 | 211 |
| 160 | 285 | 155 | 144 | 299 |
| 200 | 328 | 180 | 172 | 352 |
| 240 | 368 | 205 | 201 | 406 |
| 280 | 402 | 234 | 227 | 461 |
| 360 | 463 | 279 | 281 | 560 |
| 420 | 515 | 316 | 320 | 636 |
| 500 | 563 | 349 | 360 | 709 |
| 580 | 605 | 379 | 390 | 769 |

As shown in Table 1 and FIGS. 5 and 6, the undulated pad conditioner generally had a lower cut rate than the flat pad conditioner and the cut rate of the undulated pad conditioner was more constant over time.

### EXAMPLE 2A.

Example 2A was prepared and tested in the same fashion as Example 1A except that the abrasive disk was prepared by attaching a sintered abrasive layer to the polycarbonate substrate. The sintered abrasive layer was prepared by removing the sintered layer from an A160, 3M 4980-6 pad conditioner available from 3M Co., St. Paul, MN. The sintered layer was removed after heating the pad conditioner on a hot plate until the epoxy attaching the sintered layer softened. The sintered abrasive was then attached to the polycarbonate substrate with epoxy.

The undulated pad conditioner was tested by measuring the cumulative material removed from the polycarbonate workpiece. The results are shown in Table 2.

### EXAMPLE 2B.

For Example 2 B, the abrasive disk from Example 2A was rotated (i.e. indexed) about the undulating disk 60 degrees and re-tested using the same test as Example 2A. After rotation, the three screws were located in the same through holes of the undulating disk of Example 2A and the alternate threaded holes of the abrasive disk. The screws were used to pull the substrate of the abrasive disk into contact with the backing plate of the undulating disk at the three recessed portions. The undulated pad conditioner was tested by measuring the cumulative cut of the workpiece. The results are shown in Table 2.

### COMPARATIVE EXAMPLE 2.

Comparative Example 2 was prepared in the same manner as Example 2A except the undulating plate was removed to eliminate the undulating surface. Six screws were used to hold the substrate of the abrasive layer to the backing plate. The flat pad conditioner was tested by measuring the cumulative material removed from the workpiece. The results are shown in Table 2.

**Table 2. Cumulative Cut Millimeters versus Time (seconds)**

| Time | Comparative Example 2 | Example 2A | Example 2B |
|---|---|---|---|
| 0 | 0 | 0 | 0 |
| 30 | 0.05 | 0.09 | 0.06 |
| 60 | 0.10 | 0.14 | 0.13 |
| 90 | 0.16 | 0.21 | 0.20 |
| 120 | 0.20 | 0.27 | 0.27 |
| 150 | 0.25 | 0.34 | 0.33 |
| 180 | 0.30 | 0.41 | 0.39 |
| 210 | 0.34 | 0.48 | 0.45 |
| 240 | 0.40 | 0.54 | 0.53 |
| Average cut per 30 seconds | 0.23 | 0.31 | 0.30 |

As shown in Table 2, the undulated pad conditioners had a higher average cut rate than the flat pad conditioner.

It is to be understood that even in the numerous characteristics and advantages of the present invention set forth in above description and examples, together with details of the structure and function of the invention, the disclosure is illustrative only. Changes can be made to detail, especially in matters of shape, size and arrangement of the undulated pad conditioner assembly and methods of use within the principles of the invention to the full extent indicated by the meaning of the terms in which the appended claims are expressed. For example, the undulated pad conditioner can be used for conditioning a fixed abrasive article, including three-dimensional abrasive articles and conventional lapping materials made from abrasive slurries.

## Claims

1. A pad conditioner comprising:
an abrasive disk (12) comprising an abrasive surface (16) and a second surface (14) opposite said abrasive surface (16); and
an undulating disk (10) having an undulated surface (20) proximate said second surface (14) of said abrasive disk (12), said undulating disk (10) comprising at least one raised portion (26) and at least one recessed portion (28); **characterized in that**
said abrasive disk (12) is releasably affixed to at least a portion of said recessed portion (28) to form an undulated abrasive surface (16).

2. The pad conditioner of claim 1 wherein said pad conditioner is a chemical-mechanical planarization pad conditioner.

3. The pad conditioner of claim 2 wherein said undulating disk (10) further comprises an undulating plate (20) and a backing plate (22).

4. The pad conditioner of claim 2 wherein said abrasive disk (12) further comprises a substrate (14) and an abrasive layer.

5. The pad conditioner of claim 4 wherein said substrate (14) is more flexible than said undulating disk (10).

6. The pad conditioner of claim 5 wherein said substrate (14) is formed from polycarbonate.

7. The pad conditioner of claim 4 wherein said substate (14) is releasably affixed to said recessed area (28) with at least one removable fastener (34).

8. The pad conditioner of claim 7 wherein said substrate (14) further comprises a quantity of indexing holes (38, 40), said undulating disk (10) further comprises a quantity of substrate mounting holes (24), and said substrate mounting holes (24) and said indexing holes (38, 40) are configured for said removable fastener (34).

9. The pad conditioner of claim 8 wherein said quantity of indexing holes (38, 40) is at least two times said quantity of substrate mounting holes (24).

10. The pad conditioner of claim 2 wherein said abrasive disk (12) comprises a sintered abrasive layer.

11. The pad conditioner of claim 2 further comprising at least three said recessed portions (28).

12. The pad conditioner of claim 11 wherein said undulating disk (10) comprises a patterned undulated surface (20).

13. The pad conditioner of claim 12 wherein said patterned undulated surface (20) has a step pattern.

14. The pad conditioner of claim 12 wherein said patterned undulated surface (20) comprises an offset in range from about 0.25 mm to about 0.75 mm.

15. The pad conditioner of claim 12 wherein said raised portion (26) is in a range from about 33 percent to about 66 percent of the area of said patterned undulated surface (20).

16. A method of conditioning a polishing pad comprising:
contacting said pad with an abrasive article according to claim 1; and
moving said abrasive article relative to said pad to modify a surface of said pad, **characterized in that** said abrasive article comprises an abrasive disk (12) and an undulating disk (10) that forms an undulated abrasive layer (16).

17. The method of claim 16 wherein said undulated abrasive layer (16) comprises an offset in a range from about 0.25 mm to about 0.75 mm.

18. The method of claim 16 further comprising the step of indexing said abrasive article by rotating said abrasive disk relative to said undulating disk.

19. The method of claim 16 further comprising the step of adjusting the offset of said undulated abrasive layer (16) of said abrasive disk.

20. The method of claim 16 wherein said abrasive disk is affixed to said undulating disk (10) with at least one removable fastener (34).

## Patentansprüche

1. Kissenaufbereitungsvorrichtung mit:
einer Schleifscheibe (12) aufweisend eine Schleiffläche (16) und eine gegenüber der Schleiffläche (16) liegende zweite Fläche (14); und
einer Wellenscheibe (10) mit einer gewellten Fläche (20) nahe der zweiten Fläche (14) der Schleifscheibe (12), wobei die Wellenscheibe (10) mindestens einen erhobenen Abschnitt (26) und mindestens einen vertieften Abschnitt (28) aufweist; **dadurch gekennzeichnet, dass**
die Schleifscheibe (12) lösbar an mindestens einem Abschnitt des vertieften Abschnitts (28) zur Bildung einer gewellten Schleiffläche (16) angebracht ist.

2. Kissenaufbereitungsvorrichtung nach Anspruch 1, wobei die Kissenaufbereitungsvorrichtung eine chemischmechanische Planarisierungs-Kissenaufbereitungsvorrichtung ist.

3. Kissenaufbereitungsvorrichtung nach Anspruch 2, wobei die Wellenscheibe (10) ferner eine Wellenplatte (20) und eine Rückenplatte (22) aufweist.

4. Kissenaufbereitungsvorrichtung nach Anspruch 2, wobei die Schleifscheibe (12) ferner ein Substrat (14) und eine Schleifschicht aufweist.

5. Kissenaufbereitungsvorrichtung nach Anspruch 4, wobei das Substrat (14) flexibler als die Wellenscheibe (10) ist.

6. Kissenaufbereitungsvorrichtung nach Anspruch 5, wobei das Substrat (14) aus Polycarbonat gebildet ist.

7. Kissenaufbereitungsvorrichtung nach Anspruch 4, wobei das Substrat (14) lösbar an dem vertieften Gebiet (28) mit mindestens einem entfernbaren Befestiger (34) angebracht ist.

8. Kissenaufbereitungsvorrichtung nach Anspruch 7, wobei das Substrat (14) ferner eine Anzahl Indexlöcher (38, 40) aufweist, die Wellenscheibe (10) ferner eine Anzahl Substratbefestigungslöcher (24) aufweist, und die Substratbefestigungslöcher (24) und die Indexlöcher (38, 40) für den entfernbaren Befestiger (34) ausgelegt sind.

9. Kissenaufbereitungsvorrichtung nach Anspruch 8, wobei die Anzahl Indexlöcher (38, 40) mindestens zweimal so hoch ist wie die Anzahl Substratbefestigungslöcher (24).

10. Kissenaufbereitungsvorrichtung nach Anspruch 2, wobei die Schleifscheibe (12) eine gesinterte Schleifschicht aufweist.

11. Kissenaufbereitungsvorrichtung nach Anspruch 2, ferner aufweisend mindestens drei der vertieften Abschnitte (28).

12. Kissenaufbereitungsvorrichtung nach Anspruch 11, wobei die Wellenscheibe (10) eine gemusterte gewellte Fläche (20) aufweist.

13. Kissenaufbereitungsvorrichtung nach Anspruch 12, wobei die gemusterte gewellte Fläche (20) ein Schrittmuster aufweist.

14. Kissenaufbereitungsvorrichtung nach Anspruch 12, wobei die gemusterte gewellte Fläche (20) einen Versatz im Bereich von ungefähr 0,25 mm bis ungefähr 0,75 mm aufweist.

15. Kissenaufbereitungsvorrichtung nach Anspruch 12, wobei der erhobene Abschnitt (26) in einem Bereich von ungefähr 33 Prozent bis ungefähr 66 Prozent des Gebiets der gemusterten gewellten Fläche (20) liegt.

16. Verfahren zur Aufbereitung eines Polierkissens, aufweisend:
Inkontaktbringen des Kissens mit einem Schleifgegenstand nach Anspruch 1; und
Bewegen des Schleifgegenstands relativ zum Kissen zur Modifizierung einer Fläche des Kissens; **dadurch gekennzeichnet, dass** der Schleifgegenstand eine Schleifscheibe (12) und eine Wellenscheibe (10), die eine gewellte Schleifschicht (16) bildet, aufweist.

17. Verfahren nach Anspruch 16, wobei die gewellte Schleifschicht (16) einen Versatz in einem Bereich von ungefähr 0,25 mm bis ungefähr 0,75 mm aufweist.

18. Verfahren nach Anspruch 16, ferner aufweisend den Schritt des Indexierens des Schleifgegenstands durch Drehen der Schleifscheibe relativ zur Wellscheibe.

19. Verfahren nach Anspruch 16, ferner aufweisend den Schritt des Einstellens des Versatzes der gewellten Schleifschicht (16) der Schleifscheibe.

20. Verfahren nach Anspruch 16, wobei die Schleifscheibe mit mindestens einem entfernbaren Befestiger (34) an die Wellenscheibe (10) angebracht wird.

## Revendications

1. Conditionneur de plaquettes comprenant :
un disque abrasif (12) comprenant une surface abrasive (16) et une deuxième surface (14) opposée à ladite surface abrasive (16) ; et
un disque ondulé (10) comportant une surface ondulée (20) proximale à ladite deuxième surface (14) dudit disque abrasif (12), ledit disque ondulé (10) comprenant au moins une partie surélevée (26) et au moins une partie en retrait (28) ;
**caractérisé en ce que** ledit disque abrasif (12) est fixé de façon amovible à au moins une partie de ladite partie en retrait (28) pour former une surface abrasive ondulée (16).

2. Conditionneur de plaquettes selon la revendication 1, ledit conditionneur de plaquettes étant un conditionneur de plaquettes de planarisation chimique-mécanique.

3. Conditionneur de plaquettes selon la revendication 2, dans lequel ledit disque ondulé (10) comprend en outre une plaque ondulée (20) et une plaque de support (22).

4. Conditionneur de plaquettes selon la revendication 2, dans lequel ledit disque abrasif (12) comprend en outre un substrat (14) et une couche abrasive.

5. Conditionneur de plaquettes selon la revendication 4, dans lequel ledit substrat (14) est plus flexible que ledit disque ondulé (10).

6. Conditionneur de plaquettes selon la revendication 5, dans lequel ledit substrat (14) est formé de polycarbonate.

7. Conditionneur de plaquettes selon la revendication 4, dans lequel ledit substrat (14) est fixé de façon amovible à ladite zone en retrait (28) avec au moins un boulon amovible (34).

8. Conditionneur de plaquettes selon la revendication 7, dans lequel ledit substrat (14) comprend en outre un certain nombre de trous de repérage (38, 40), ledit disque ondulé (10) comprend en outre un certain nombre de trous de montage au niveau du substrat (24), et lesdits trous de montage au niveau du substrat (24) et lesdits trous de repérage (38, 40) sont configurés pour ledit boulon amovible (34).

9. Conditionneur de plaquettes selon la revendication 8, dans lequel ledit nombre de trous de repérage (38, 40) est d'au moins deux fois ledit nombre de trous de montage au niveau du substrat (24).

10. Conditionneur de plaquettes selon la revendication 2, dans lequel ledit disque abrasif (12) comprend une couche abrasive frittée.

11. Conditionneur de plaquettes selon la revendication 2, comprenant en outre au moins trois desdites parties en retrait (28).

12. Conditionneur de plaquettes selon la revendication 11, dans lequel ledit disque ondulé (10) comprend une surface ondulée pourvue d'un motif (20).

13. Conditionneur de plaquettes selon la revendication 12, dans lequel ladite surface ondulée pourvue d'un motif (20) comporte un motif en gradins.

14. Conditionneur de plaquettes selon la revendication 12, dans lequel ladite surface ondulée pourvue d'un motif (20) comporte un décalage d'environ 0,25 mm à environ 0,75 mm.

15. Conditionneur de plaquettes selon la revendication 12, dans lequel ladite partie surélevée (26) représente d'environ 33 % à environ 66 % de la superficie de ladite surface ondulée pourvue d'un motif (20).

16. Procédé de conditionnement d'une plaquette de polissage, comprenant :
la mise en contact de ladite plaquette avec un article abrasif selon la revendication 1 ; et
le déplacement dudit article abrasif par rapport à ladite plaquette pour modifier une surface de ladite plaquette,
**caractérisé en ce que** ledit article abrasif comprend un disque abrasif (12) et un disque ondulé (10) qui forme une couche abrasive ondulée (16).

17. Procédé selon la revendication 16, dans lequel ladite couche abrasive ondulée (16) comporte un décalage d'environ 0,25 mm à environ 0,75 mm.

18. Procédé selon la revendication 16, comprenant en outre l'étape de déplacement relatif dudit article abrasif par rotation dudit disque abrasif par rapport audit disque ondulé.

19. Procédé selon la revendication 16, comprenant en outre l'étape d'ajustement du décalage de ladite couche abrasive ondulée (16) dudit disque abrasif.

20. Procédé selon la revendication 16, dans lequel ledit disque abrasif est fixé audit disque ondulé (10) avec au moins un boulon amovible (34).
